# EUROPEAN PATENT APPLICATION

(11) **EP 4 137 605 A1**
(43) Date of publication of application: **22.02.2023**
(21) Application number: 21192216.6
(22) Date of filing: 19.08.2021
(51) Int. Cl.: C23C 16/16, H01L 21/285, C07F 11/00, C07F 15/00

(54) **METHOD FOR MAKING METAL TRIMETHYLENEMETHANE-CARBONYL COMPLEXES**

(71) Applicant: UMICORE AG & Co. KG, 63457 Hanau-Wolfgang (DE)
(72) Inventor: SCHORN, Wolf, 76337 Waldbronn (DE); FREY, Annika, 63457 Hanau (DE); GLUER, Arne, Hanau (DE); KARCH, Ralf, 63801 Kleinostheim (DE); RAU, Nicholas, 35039 Marburg (DE); ZYULKOV, Ivan, 1200 Brüssel (BE)

(57) **Abstract**

The Invention relates to a simple two-step method of making highly pure compounds of formula 1 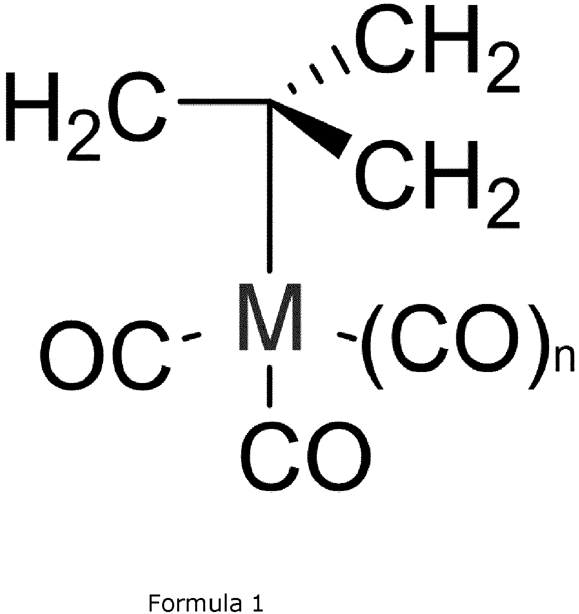 with n being 1 or 2 and M being ruthenium or molybdenum from starting materials readily available.

## Description

Two of the materials expected to be introduced into high volume manufacturing are Ruthenium (Ru) and molybdenum (Mo). They can be used as a liner/barrier material for Cu electroplating and also as a bulk fill material for via structures in back-end-of-line (BEOL) and well as contact materials in the middle-of-line (MOL). In these applications Ru or Mo metal needs to be deposited by chemical vapor deposition (CVD), atomic layer deposition (ALD) or other methods.

The challenge to be solved is to deposit these metals with low impurities, such as C, O or N into a patterned structure without defects such as voids or seams. One of the approaches could be selective deposition of Ruthenium or Molybdenum via atomic layer deposition (ALD) or chemical vapor deposition (CVD) on a metal bottom of the via or metal silicide bottom of a contact hole, while preventing Ruthenium or molybdenum growth on dielectric sidewalls.

Ruthenium and Molybdenum complexes based on carbonyl ligands show in many cases very good performance in ALD and CVD processes for thin layers due to selective chemisorption of these precursors on specific surfaces, such as metal surfaces with respect to less polar dielectric surfaces. Current state-of-the-art are molybdenum hexacarbonyl Mo(CO)₆ and Ru₃(CO)₁₂ (dodecacarbonyl ruthenium, often abbreviated as DCR, CAS-Nr. 15243-33-1), which is one of the most selective CVD precursors. There are, however, several disadvantages to e.g. DCR process, such as:
- it is a solid, which prevents utilization of bulk liquid refill systems typically used in a fab, which prevents usage of automatic refill of a resident on-tool canister from a bulk container in a sub fab. In addition, it can cause problems in nonoptimized deposition processes due to resublimation on cold spots, eventually leading to clogging of pipes and tubes.
- it has comparably high oxygen and carbon content derived from the carbonyl ligands, leading to oxygen impurities in the desired Ru(0) layers.
- its comparably low vapor pressure, which leads to low concentrations of ruthenium in the gas phase, thus directly reducing the amount of ruthenium that can be deposited per time, and
- it is not easy to prepare pure dodecacarbonyl ruthenium.
- it has poor stability due to easy elimination of the first carbonyl ligands, therefore DCR behaves as a CVD precursor, rather than an ALD precursor.

The same concerns apply, mutatis mutandis, to molybdenum hexacarbonyl Mo(CO)₆, in particular with regard to the stability in a gas phase deposition process.

As a summary, liquid Ruthenium or Molybdenum precursors with superior volatility capable of depositing pure metal Ruthenium or Molybdenum are needed in order to improve the performance of Ruthenium and/or Molybdenum deposition processes for MOL (Middle of Line) and BEOL (Back End of Line) application.

Kotsugi et al., Chem. Mater. 2021, 33, 14, 5639-5651 shows that a promising compound that is capable of depositing such layers is known as Trimethylenemethyl ruthenium tricarbonyl [Ru(tmm)(CO)₃]:

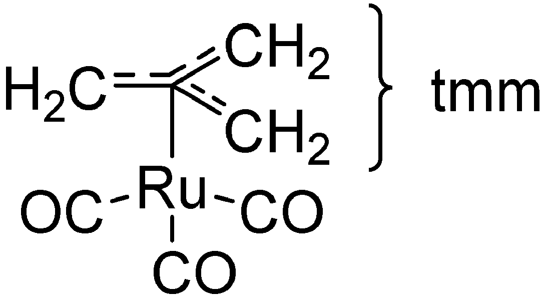

The trimethylenemethyl ligand in this compound is marked up by the curly bracket.

Generally, such metal(tmm)(CO)₃ compounds, in particular of ruthenium and molybdenum, in general would be desirable compounds for the applications mentioned above and in the art.

Herberich et al., Journal of the Chemical Society - Dalton Transactions, 1993, p. 2471 to 2476 shows that Ru(tmm)(CO)₃ can be prepared via a four-step-synthesis. This synthetic procedure employs RuCl₂(CO)₃ (CAS-Nr.: 22594-69-0) as an intermediate, which is laborious to prepare in a pure state and the desired ligand, trimethylenemethane (tmm), is introduced via the tmm-synthon (Me₃Sn)₂(tmm) (CAS-Nr.: 86854-54-8) which contains toxic Sn-moieties, bringing with it the risk of hazardous havaries as well as expensive disposal of Sn-containing by products. Moreover, (Me₃Sn)₂tmm itself is prepared from the very sensitive, pyrophoric potassium compound K₂tmm (CAS-Nr.: 64544-49-6).

The molybdenum compound 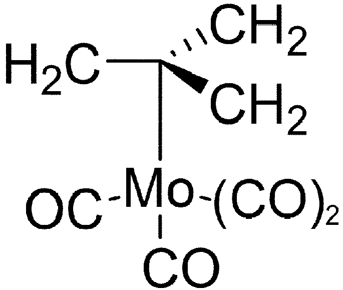 is known as such, but not its use in gas phase deposition processes and is shown in John M. Maher, Organometallics 1982, 1, 215-217 as well with its synthesis

The problem is the provision of pure metal(tmm)(CO)₃ compounds of ruthenium and molybdenum that is easy to carry out with common starting materials that are less toxic and dangerous than (Me₃Sn)₂tmm. This problem is solved according to the claims and the description below.

### Short Description of the Invention

1. Method of making a compound of formula 1 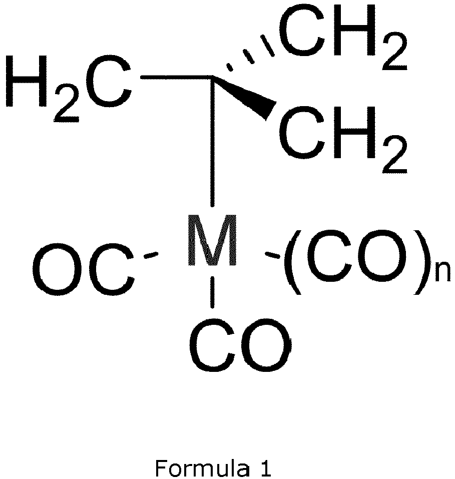 with the metal M being selected from ruthenium or molybdenum, n being 1 or 2, comprising the steps of:
   - Reacting a carbonyl of the metal M with 2-methylallylhalide in the presence of a first solvent at a first temperature sufficient to allow a reaction to obtain the respective metal-(η³methylallyl)halo-carbonyl;
   - Reaction of the metal-(η³methylallyl)halo-carbonyl with a base and optionally in the presence of a second solvent at a second temperature sufficient to allow deprotonation thereof and formation of the compound of formula 1.
2. Method of item 1, wherein M is ruthenium and n is 1 or M is molybdenum and n is 2.
3. Method of item 1 or 2, wherein the metal carbonyl is dodecacarbonyl ruthenium or bipiperidino molybdenum tetracarbonyl.
4. Method of any of items 1 to 3, wherein the 2-methylallylhalide is 2-methylallylchloride, 2-methylallylbromide or 2-methylallyliodide, in particular 2-methylallylchloride.
5. Method of any of items 1 to 4, wherein the first solvent is a hydrocarbon with a boiling point of at least 80°C or a base.
6. Method of any of items 1 to 5, wherein the first solvent is an aromatic or aliphatic hydrocarbon, in particular at least one alkane, or an amine.
7. Method of any of items 1 to 6, wherein the first solvent is heptane or a tertiary amine, in particular triethylamine.
8. Method of any of items 1 to 7, wherein the first temperature is less than the boiling point of the first solvent.
9. Method of any of items 1 to 8, wherein the first temperature is from 70°C to 110°C, in particular from 75°C to 100°C.
10. Method of any of items 1 to 9, wherein the metal-(η³methylallyl)halo-carbonyl is [Ru(η³-methylallyl)Cl(CO)₃] or [Mo(η³-methylallyl)Cl(CO)₄].
11. Method of any of items 1 to 10, wherein the base is an amine, in particular a tertiary amine, an alkaline alcoholate, in particular potassium tert.-butanolate or an alkaline amide, in particular lithium diisopropylamide, or an alkali carbonate, in particular sodium carbonate.
12. Method of any of items 1 to 11, wherein the second solvent is an amine, in particular a tertiary amine, or an ether, in particular a cyclical ether, more specifically 2-Ethoxy-2-methylpropan, isobutylmethylether, 2-methoxy-2-methyl propane, n-butylmethylether, sec-Butylmethylether, tetrahydrofurane, 1,3-dioxane or 1,4-dioxane.
13. Method of any of items 1 to 12, wherein the second temperature is from 50°C to 100°C, in particular from 55 to 80°C or from 60°C to 75°C or equals the boiling point of the second solvent.
14. Method of any of items 1 to 13, wherein the 2-methylallylhalide is employed in an amount of 10 to 20 equivalents, in particular 14 to 17 equivalents, in relation to the amount of metal of the metal carbonyl.
15. Method of any of items 1 to 13, wherein the base is employed in an equimolar amount in relation to the metal-(η³methylallyl)halo-carbonyl.
16. Method of any of items 1 to 13, wherein the compound of formula 1 is a compound of formula 2 or 3: 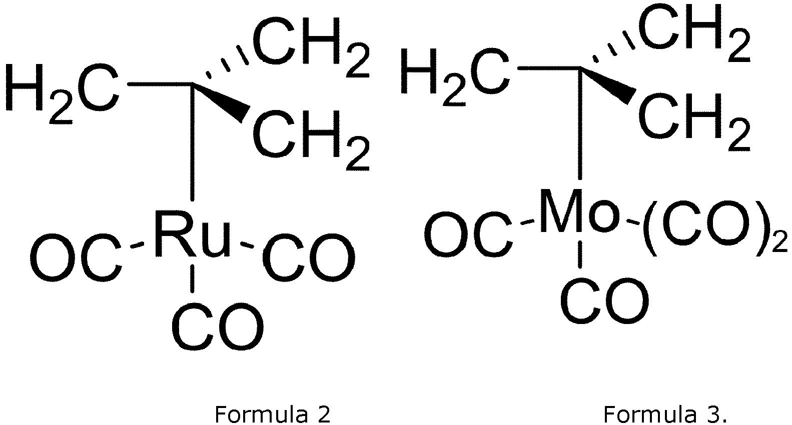
17. The compound of formula 2 or 3 of item 16, wherein the tin content is lower than 5 ppm, in particular 150 ppb or less.
18. The use of a compound of formula 2 or 3 of item 16 for Atomic Layer Deposition (ALD) or Chemical Vapour Deposition (CVD).
19. A method for CMD, Atomic Layer Deposition or Chemical Vapour Deposition comprising the steps of
   - Providing a compound of formula 2 or 3 according to claim 1 or 16, preferably in a method according to any of claims 1 to 15;
   - Subjecting said compound of formula 2 or 3 to Atomic Layer Deposition or Chemical Vapour Deposition.

### Detailed Description of the Invention

The problem is solved by a Method of making a compound of formula 1 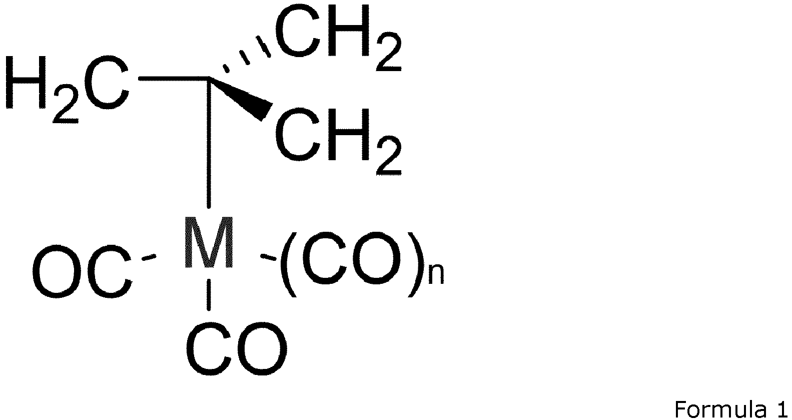 with the metal M being selected from ruthenium or molybdenum, n being 1 or 2, comprising the steps of:
- Reacting a suitable carbonyl of the metal M with 2-methylallylhalide in the presence of a first solvent at a first temperature sufficient to allow a reaction to obtain the respective metal-(η³methylallyl)halo-carbonyl;
- Reaction of the metal-(η³methylallyl)halo-carbonyl with a base and optionally in the presence of a second solvent at a second temperature sufficient to allow deprotonation thereof and formation of the compound of formula 1.

More specifically, in Formula 1 n is 1 if M is ruthenium and n is 2 if M is molybdenum.

For making the ruthenium compound, a suitable carbonyl of ruthenium is dodecacarbonyl ruthenium, a compound known and commercially available in various qualities and purities of the structure

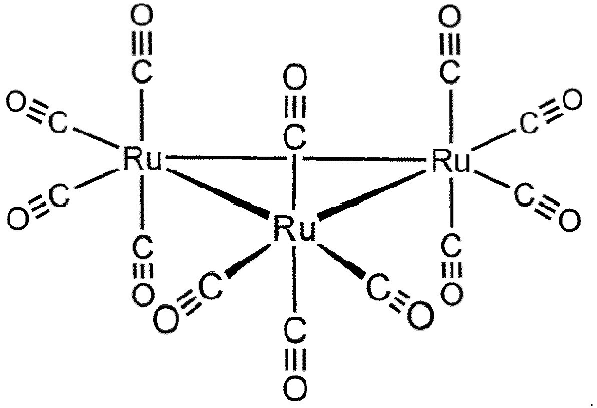

The corresponding molybdenum compound, molybdenum hexacarbonyl, exhibiting the structure 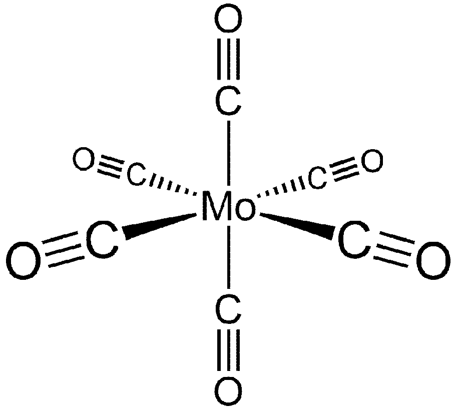 is, however, not suitable for the method of the Invention. It can be easily converted into a suitable carbonyl by reaction with piperidine to bipiperidino molybdenum tetracarbonyl, Mo(Hpip)₂(CO)₄. This reaction is known and is described in Donald J. Darensbourg et al., Inorg. Chem. 1978, 17, 2680-2682.

The suitable carbonyl of the metal M is then reacted with a 2-methylallylhalide, in particular with 2-methylallylchloride, 2-methylallylbromide or 2-methylallyliodide, in particular 2-methylallylchloride. This reaction is carried out in a first solvent, which can be a a hydrocarbon with a boiling point of at least 80°C or a base, such as heptane, for example. More specifically, the first solvent may be an aromatic or aliphatic hydrocarbon, in particular at least one alkane, or an amine. In particular, the first solvent can be cyclohexane, heptane, octane, benzene, toluene, ortho-, meta-, oder para-xylene or mesitylene, triethyl amine, tripropyl amine, tributyl amine, dipropyl amine, dibutyl amine or pyridine, for example.

The reaction temperature can be less than the temperature of the boiling point of the solvent. The reaction can be carried out at temperatures of from about 60°C to about 125°C, or of from about 65°C to about 111°C, in particular of from about 70°C to about 110°C, more specifically from about 75°C to about 100°C. The temperatures given above can be used as temperatures of a heating medium, such as an oil bath.

This reaction can be carried out overnight, that is for about 10 to about 18 hours, in particular from about 12 to about 16 hours.

The 2-methylallylhalide is employed in an amount of about 10 to about 20 equivalents, in particular about 14 to about 17 equivalents in relation to the amount of metal of the carbonyl of the metal M.

The product of this reaction, the first step of this synthesis, is a metal-(η³methylallyl)halo-carbonyl, such as ruthenium (η³⁻methylallyl) tricarbonyl chloride [Ru(η³-methylallyl)Cl(CO)₃] or molybdenum (η³⁻methylallyl) tetracarbonyl chloride [Mo(_{η}³-methylallyl)Cl(CO)₄].

After the reaction mixture is cooled to room temperature, it is filtered and the solvent is partially or completely removed. In general, it is practical to partially remove the solvent, in particular about half of the solvent, then cool to 0°C to precipitate the reaction product, which can then be filtered off and washed with cold solvent. Removal of the solvent can, in general, be carried out e.g. by distillation under reduced pressure.

In particular for ruthenium, it has been found that this reaction is also suitable for employing qualities of dodecacarbonyl ruthenium having lower purities, or, mutatis mutandis, containing higher quantities of impurities. After the reaction, the impurities, which in general comprise iron and iron compounds, other platinum group metals, ruthenium chlorocarbonyls or ruthenium hydroxides, will be insoluble in the solvent, in particular heptane, and can be filtered off, thus allowing to prepare a high purity metal-(η³methylallyl)halo-carbonyl intermediate (and thus, subsequently end product) from a low-purity starting material. Depending on the purity of the starting materials, in particular the dodecacarbonyl ruthenium, it is possible to completely remove the solvent and to collect the reaction product.

In the following step of the method the metal-(η³methylallyl)halo-carbonyl, that is the ruthenium (η³-methylallyl) tricarbonyl chloride [Ru(η³-methylallyl)Cl(CO)₃] or molybdenum (η³-methylallyl) tetracarbonyl chloride [Mo(η³-methylallyl)Cl(CO)₄] obtained in the first step as an intermediate, is reacted with a base, which can be optionally carried out in the presence of a second solvent. The reaction is carried out at second temperature sufficient to allow deprotonation of the metal-(η³methylallyl)halo-carbonyl, which results in the formation of the end product, the compound of Formula 1.

The base can be, for instance, an amine, an alkaline alcoholate, an alkaline amide or an alkaline carbonate. More specifically, the base can be a tertiary amine such as triethylamine or tributylamine, potassium tert.-butanolate, lithium diisopropylamide, sodium carbonate.

The second solvent can be an amine, in particular a tertiary amine, or an ether, in particular a cyclical ether. If a liquid amine such as pyridine or triethylamine are employed as the base, it may simultaneously be the second solvent. Alternatively, a liquid amine may be employed as the base in the presence of the second solvent that is no amine.

More specifically, the second solvent can be 2-Ethoxy-2-methylpropan, isobutylmethylether, 2-methoxy-2-methyl propane, n-butylmethylether, sec-Butylmethylether, tetrahydrofurane, 1,3-dioxane or 1,4-dioxane.

In general the second temperature can be from about 50°C to about 100°C, in particular from about 55 to about 80°C or from about 60°C to about 75°C or the second temperature equals the boiling point of the second solvent. The base can be employed in an equimolar amount in relation to the metal-(η³methylallyl)halo-carbonyl. The reaction can be carried out by simply refluxing for about one to five hours, in particular three to four hours, more specifically about two hours, or from about one and a half to about two and a half hours.

After the reaction, the solvent can be removed in vacuo. The product may be further purified. It has shown to be practicable to purify the product by means of a bulb-to-bulb distillation in vacuo.

In this way, the desired compounds of formulae 2 and 3 can be obtained

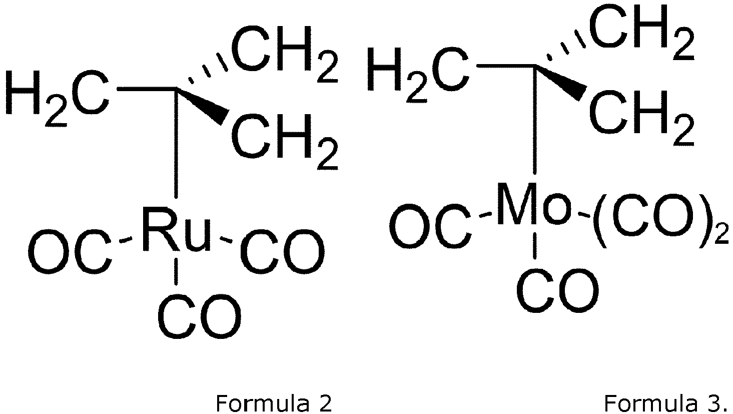

These compounds obtained by the method of the Invention exhibit a tin content of less than about 5 ppm, in particular 150 ppb or less and/or exhibit a magnesium content of less than about 5 ppm, in particular 150 ppb.

Thus, the present Invention also relates to compounds of formulae 2 and 3 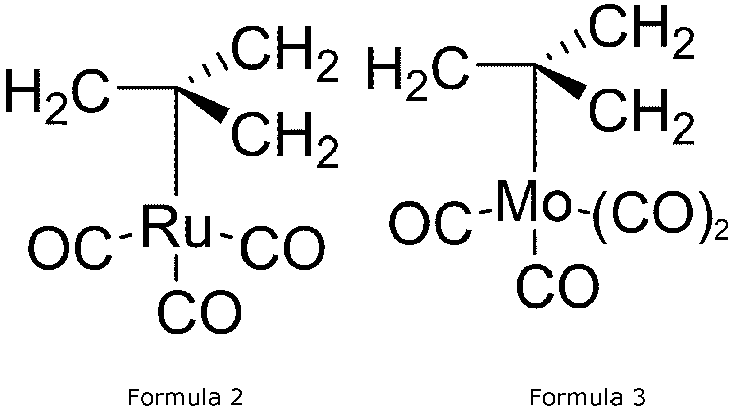 exhibiting a tin content of less than about 5 ppm, in particular 150 ppb or less.

The Invention also relates to compounds of formulae 2 and 3 exhibiting a magnesium content of less than about 5 ppm, in particular 150 ppb or less.

The Invention also relates to the use of a compound of formula 1, 2 or 3 for Atomic Layer Deposition (ALD) or Chemical Vapour Deposition (CVD).

The Invention also relates to a method for Atomic Layer Deposition or Chemical Vapour Deposition comprising the steps of

Providing a compound of formula 1, 2 or 3, preferably obtained by the method of the Invention;

Subjecting said compound of formula 1 or 2 to Atomic Layer Deposition or Chemical Vapour Deposition.

With this method a substrate is provided with a ruthenium or molybdenum coating or layer or with a coating or layer comprising ruthenium or molybdenum.

Thus, the present Invention also relates to a Method for depositing elemental ruthenium layers, molybdenum layers, ruthenium-containing layers or molybdenum-containing layers on a surface comprising the steps of
- providing a compound according to formula 1, 2 or 3;
- subjecting said compound of formula 1, 2 or 3 a method to deposit elemental ruthenium layers or ruthenium-containing layers on a surface. The method to deposit elemental ruthenium layers or ruthenium-containing layers on a surface can be Atomic Layer Deposition (ALD) or Chemical Vapour Deposition (CVD).

In a specific embodiment of the Invention, under 1 in Scheme 1 dodecacarbonyl ruthenium DCR is mixed with heptane under inert conditions (dried and degassed), followed by addition of about 14 to 17 molar equivalents (based on the amount of metal in the DCR) of 2-methylallylchloride. The mixture is heated in an oil bath with a temperature of about 70°C to about 80°C overnight, that is about 14 hours and then cooled to ambient temperature and filtered to remove impurities. The clear filtrate is evaporated at a temperature of about 30°C to about 50°C in vacuum until about half of the heptane is removed and is subsequently cooled to about 0°C and filtered. The solid is filtered off and dried in vacuum. The yellow solid is the intermediate [Ru(η³-methylallyl)Cl(CO)₃].

To obtain the final product [Ru(tmm)(CO)₃], under 2 of the scheme 1 [Ru(η³-methylallyl)Cl(CO)₃] is dissolved in THF (tetrahydrofurane) under inert conditions and potassium tert.-butanolate is added as a base. This can be done either by adding the solid or preferably by means of a stock solution of potassium tert.-butanolate in THF. Base should be added at least in an equimolar amount to the [Ru(η³-methylallyl)Cl(CO)₃]. The resulting mixture is refluxed for a few hours such as one to four hours, depending on the scale of the reaction. After cooling to ambient temperature and filtration the solvent is evaporated. The product [Ru(tmm)(CO)₃] so obtained can be further purified by vacuum distillation.

In another embodiment of the Invention, [Mo(tmm)(CO)₄] is prepared as depicted in scheme 2.

If necessary, the educt bipiperidino molybdenum tetracarbonyl, Mo(Hpip)₂(CO)₄ can be prepared by reaction of molybdenum hexacarbonyl with piperidine under 3 in the above scheme as described in Donald J. Darensbourg et al., Inorg. Chem. 1978, 17, 2680-2682.

Under 4 in Scheme 2 the bipiperidino molybdenum tetracarbonyl, Mo(Hpip)₂(CO)₄ can be mixed with heptane and 14 to 17 molar equivalents (based on the amount of metal in the DCR) of 2-methylallylchloride under inert conditions. The mixture is then stirred at an internal temperature of about 70°C to about 80°C overnight, which in general is about 14 hours. After removal of about half of the solvent by distillation under reduced pressure at about 30°C to about 40°C it is cooled to 0°C and the intermediate product, [Mo(2-methylallyl)Cl(CO)₄] is filtered off, washed with cold solvent with a temperature of about 0°C and dried in vacuum.

[Mo(2-methylallyl)Cl(CO)₄] is reacted to the final product under 5 of Scheme 2 with an equimolar amount of potassium tert.-butanolate in THF as solvent and under inert conditions. The potassium tert.-butanolate can be added slowly as stock solution in THF in about equimolar amount. The resulting mixture is refluxed for a few hours such as one to four hours, depending on the scale of the reaction. After cooling to ambient temperature and filtration the solvent is evaporated. The product [Mo(tmm)(CO)₄] so obtained can be further purified by vacuum distillation.

### Examples

### Example 1: Preparation of [Ru(tmm)(CO)₃]

### Step 1: Synthesis of the intermediate [Ru(η³-methylallyl)Cl(CO)₃]:

45 g of DCR are suspended in 690 mL dried and degassed heptane. 315 g of 2-methylallylchloride are added at room temperature to the suspension. The reaction mixture is stirred overnight at 75°C oilbath temperature. After cooling to room temperature, the resulting suspension is filtered and the volume of the clear filtrate is reduced under reduced pressure at 35°C in a distillation apparatus. 350 mL of heptane are collected via distillation, the resulting suspension is cooled to 0°C and filtered at this temperature. The isolated yellow solid is dried in vacuo at room temperature to give 38,8 g of the intermediate [Ru(η³-methylallyl)Cl(CO)₃] (67%); Another crop of 14,3 g (i. e. 25%) of slightly impure [Ru(η³-methylallyl)Cl(CO)₃] can be isolated by evaporating the solvents of the clear filtrate.

### Step 2: Synthesis of final product [Ru(tmm)(CO)₃]\:

5 g of [Ru(η³-methylallyl)Cl(CO)₃] is dissolved in 37.5 mL dried and degassed THF. 18.1 mL of a 1-molar solution of KOtBu in THF is added at room temperature. During the addition, a slight temperature raise can be seen (+10°C). The reaction mixture is refluxed for two hours. After that the reaction mixture is cooled to room temperature and filtrated. The solvents are removed by distillation, and the final product is isolated by vacuum distillation. 1.47 g of a colorless oil was isolated (34%).

### Example 2: Synthesis of [Mo(tmm)(CO)₄]

### Step 1:

5.3 grams of bipiperidino molybdenum tetracarbonyl, Mo(Hpip)₂(CO)₄ (20 mmol) are suspended in 85 mL of heptane and 30 g of 2-methylallyl chloride (330 mmol) are added at room temperature. Afterwards the reaction mixture is stirred over night for about 12 hours at an internal temperature of 70°C. After reduction of the reaction mixture volume at 35°C under reduced pressure, the reaction mixture is cooled to 0°C and the precipitated product is collected via filtration. The filter cake is washed with cold heptane and dried in vacuo afterwards. 3.9 g of the product are isolated (13.2 mmol, 66%).

### Step 2:

3 g of [Mo(2-methylallyl)Cl(CO)₄] (10,0 mmol) are dissolved in 20 mL of THF and while stirring at room temperature, 10 mL of a KOtBu solution in THF (c = 1 mol/L, 10 mmol) are added slowly. After the addition the resulting mixture is stirred for two hours at reflux and afterwards cooled to room temperature. The precipitated potassium chloride is filtered off and the solvent of the filtrate is evaporated in vacuo. The remaining oil is purified by bulb-to-bulb distillation to give 0.9 g of [Mo(tmm)(CO)₄], a colorless liquid (3.4 mmol, 34%).

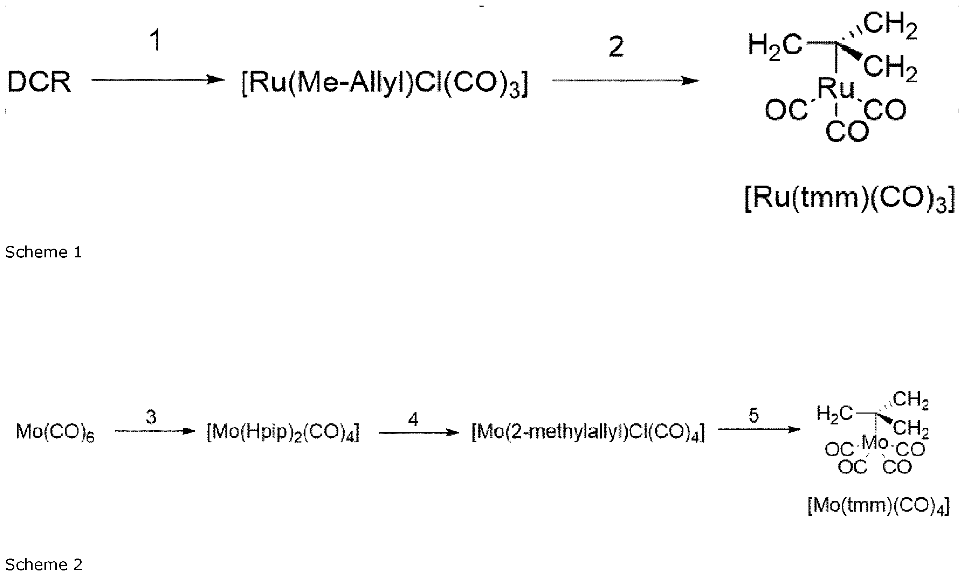

## Claims

1. Method of making a compound of formula 1 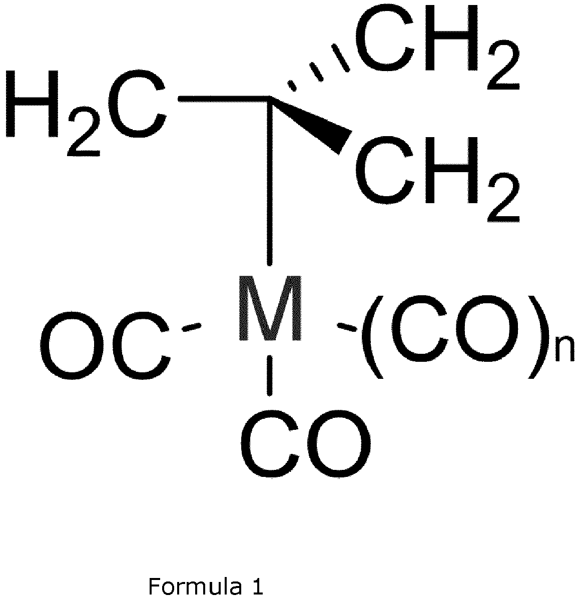 with the metal M being selected from ruthenium or molybdenum, n being 1 or 2, comprising the steps of:
- Reacting a suitable carbonyl of the metal M with 2-methylallylhalide in the presence of a first solvent at a first temperature sufficient to allow a reaction to obtain the respective metal-(η³methylallyl)halo-carbonyl;
- Reaction of the metal-(η³methylallyl)halo-carbonyl with a base and optionally in the presence of a second solvent at a second temperature sufficient to allow deprotonation thereof and formation of the compound of formula 1.

2. Method of claim 1, wherein M is ruthenium and n is 1 or M is molybdenum and n is 2.

3. Method of claim 1 or 2, wherein the metal carbonyl is dodecacarbonyl ruthenium or bipiperidino molybdenum tetracarbonyl.

4. Method of any of claims 1 to 3, wherein the 2-methylallylhalide is 2-methylallylchloride, 2-methylallylbromide or 2-methylallyliodide, in particular 2-methylallylchloride.

5. Method of any of claims1 to 4, wherein the first solvent is a hydrocarbon with a boiling point of at least 80°C or a base.

6. Method of any of claims 1 to 5, wherein the first solvent is an aromatic or aliphatic hydrocarbon, in particular at least one alkane, or an amine.

7. Method of any of claims 1 to 6, wherein the first solvent is heptane or a tertiary amine, in particular triethylamine.

8. Method of any of claims 1 to 7, wherein the first temperature is less than the boiling point of the first solvent.

9. Method of any of claims 1 to 8, wherein the first temperature is from 70°C to 110°C, in particular from 75°C to 100°C.

10. Method of any of claims 1 to 9, wherein the metal-(η³methylallyl)halo-carbonyl is [Ru(η³-methylallyl)Cl(CO)₃] or [Mo(η³-methylallyl)Cl(CO)₄].

11. Method of any of claims 1 to 10, wherein the base is an amine, in particular a tertiary amine, an alkaline alcoholate, in particular potassium tert.-butanolate or an alkaline amide, in particular lithium diisopropylamide, or an alkali carbonate, in particular sodium carbonate.

12. Method of any of claims 1 to 11, wherein the second solvent is an amine, in particular a tertiary amine, or an ether, in particular a cyclical ether, more specifically 2-Ethoxy-2-methylpropan, isobutylmethylether, 2-methoxy-2-methyl propane, n-butylmethylether, sec-Butylmethylether, tetrahydrofurane, 1,3-dioxane or 1,4-dioxane.

13. Method of any of claims 1 to 12, wherein the second temperature is from 50°C to 100°C, in particular from 55 to 80°C or from 60°C to 75°C or equals the boiling point of the second solvent.

14. Method of any of claims 1 to 13, wherein the 2-methylallylhalide is employed in an amount of 10 to 20 equivalents, in particular 14 to 17 equivalents, in relation to the amount of metal of the metal carbonyl.

15. Method of any of claims 1 to 13, wherein the base is employed in an equimolar amount in relation to the metal-(η³methylallyl)halo-carbonyl.

16. Method of any of claims 1 to 13, wherein the compound of formula 1 is a compound of formula 2 or 3:

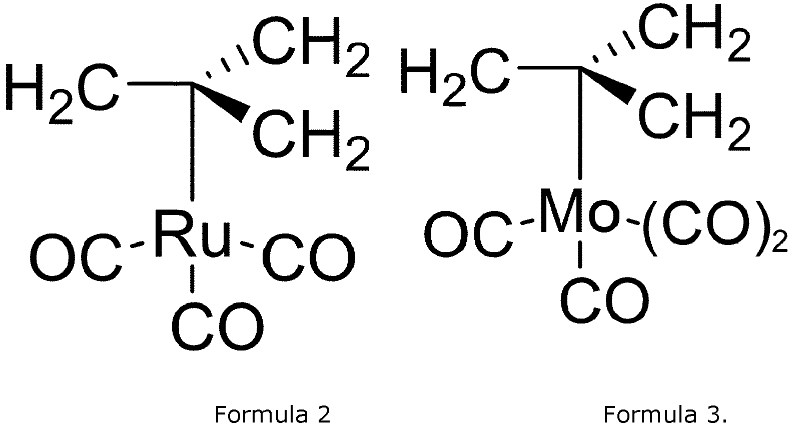

17. The compound of formula 1, 2 or 3, wherein the tin content is lower than 5 ppm, in particular 150 ppb or less.

18. The compound of formula 1, 2 or 3, wherein the magnesium content is lower than 5 ppm, in particular 150 ppb or less.

19. The use of a compound of formula 1, 2 or 3 for Atomic Layer Deposition (ALD).

20. The use of a compound of formula 1, 2 or 3 for Chemical Vapour Deposition (CVD).

21. A method for Atomic Layer Deposition comprising the steps of
- Providing a compound of formula 1, 2 or 3 according to claim 1 or 16, preferably in a method according to any of claims 1 to 18;
- Subjecting said compound of formula 1, 2 or 3 to Atomic Layer Deposition.

22. A method for Chemical Vapour Deposition comprising the steps of
- Providing a compound of formula 1, 2 or 3 according to claim 1 or 16, preferably in a method according to any of claims 1 to 18;
- Subjecting said compound of formula 1, 2 or 3 to Chemical Vapour Deposition.

23. Method for depositing elemental ruthenium layers, molybdenum layers, ruthenium-containing layers or molybdenum-containing layers on a surface comprising the steps of
- providing a compound according to formula 1, 2 or 3;
- subjecting said compound of formula 1, 2 or 3 to a method for depositing elemental ruthenium layers, elemental molybdenum layers, ruthenium-containing layers or molybdenum containing layers on a surface.

24. A Method of claim 23, the method for depositing elemental ruthenium layers, elemental molybdenum layers, ruthenium-containing layers or molybdenum containing layers on a surface being ALD (Atomic Layer Deposition).

25. A Method of claim 23, the method for depositing elemental ruthenium layers, elemental molybdenum layers, ruthenium-containing layers or molybdenum containing layers on a surface being CVD (Chemical Vapour Deposition).
